# FASCICULE DE BREVET EUROPEEN

(11) **EP 3 347 917 B1**
(45) Date de publication et mention de la délivrance du brevet: **30.10.2019**
(21) Numéro de dépôt: 16777719.2
(22) Date de dépôt: 09.09.2016
(51) Int. Cl.: H01L 25/16, H01L 27/146, H01L 31/173, H01L 33/18, H01L 27/15, H01L 33/08

(54) **DISPOSITIF ELECTROLUMINESCENT A CAPTEUR DE LUMIERE INTEGRE**
ELEKTROLUMINESZENTE VORRICHTUNG MIT INTEGRIERTEM LICHTSENSOR
ELECTROLUMINESCENT DEVICE WITH INTEGRATED LIGHT SENSOR

(30) Priorité: 10.09.2015 FR 1558408
(43) Date de publication de la demande: 18.07.2018
(73) Titulaire: Aledia, 38040 Grenoble (FR)
(72) Inventeur: DUPONT, Tiphaine, 38000 Grenoble (FR); DORNEL, Erwan, 38800 CHAMPAGNIER (FR)
(74) Mandataire: Cabinet Beaumont
(86) Numéro de dépôt international: PCT/FR2016/052275
(87) Numéro de publication internationale: WO 2017/042512

(56) Documents cités:
- FR-A1- 3 011 381
- JP-A- 2006 278 368
- JP-B2- 2 879 971
- US-A1- 2011 079 796

## Description

La présente demande de brevet revendique la priorité de la demande de brevet français FR15/58408.

### Domaine

La présente invention concerne de façon générale les dispositifs électroluminescents à base de matériaux semiconducteurs et leurs procédés de fabrication. Par dispositifs électroluminescents, on entend des dispositifs adaptés à effectuer la conversion d'un signal électrique en un rayonnement électromagnétique.

### Exposé de l'art antérieur

Pour certaines applications, il est souhaitable de mesurer le rayonnement émis par un dispositif électroluminescent. C'est le cas notamment pour réaliser des tests au cours de la fabrication du dispositif électroluminescent ou lorsque le dispositif électroluminescent est en fonctionnement. La mesure du rayonnement émis par un dispositif électroluminescent peut être réalisée au moyen d'un capteur de lumière, comprenant au moins une photodiode, distinct du dispositif électroluminescent, ce qui entraîne un surcoût. En outre, pour réaliser une mesure en continu de la lumière, le capteur de lumière doit généralement être placé dans le champ d'émission du dispositif électroluminescent et, de ce fait, bloquer une partie du flux lumineux qui serait perçu par un observateur, ce qui n'est pas souhaitable.

Il serait souhaitable de pouvoir réaliser le capteur de lumière de façon intégrée avec le dispositif électroluminescent. Ceci permettrait de mesurer facilement le rayonnement émis par le dispositif électroluminescent à des instants voulus, et notamment de façon continue. Le capteur de lumière pourrait, en outre, être placé de façon à mesurer directement le rayonnement émis par les couches actives du dispositif électroluminescent avant qu'il ne soit modifié par d'autres éléments du dispositif électroluminescent.

La demande de brevet WO2014/154657 décrit un dispositif optoélectronique comprenant un capteur de lumière intégré. Le dispositif optoélectronique comprend des diodes électroluminescentes ayant la forme de nanofils semiconducteurs. Certains des fils, normalement utilisés pour réaliser des diodes électroluminescentes, sont modifiés pour former le capteur de lumière.

Un inconvénient du dispositif optoélectronique décrit dans la demande de brevet WO2014/154657 est que le rendement du capteur de lumière peut être faible. En outre, les fils utilisés pour le capteur de lumière ne participent plus à l'émission lumineuse du dispositif optoélectronique. La puissance lumineuse maximale pouvant être émise par un tel dispositif optoélectronique est donc inférieure à celle d'un dispositif optoélectronique de mêmes dimensions dans lequel tous les fils semiconducteurs sont dédiés à l'émission lumineuse.

JP 2006 278368 A divulgue un dispositif optoélectronique comprenant des diodes électroluminescentes LED de type mesa formées sur un substrat et des photodiodes PD, chaque photodiode étant située entre deux paires de diodes électroluminescentes.

US 2011/079796 A1 divulgue un dispositif optoélectronique comprenant une diode électroluminescente filaire, notamment à base de GaN, formée sur un substrat en Si et une photodiode formée dans le substrat sous la diode électroluminescente, et prévoit en outre de recouvrir en partie la photodiode par une couche réfléchissante.

### Résumé

Ainsi, un objet d'un mode de réalisation est de pallier au moins en partie les inconvénients des dispositifs électroluminescents à capteur de lumière intégré décrits précédemment et de leurs procédés de fabrication.

Un autre objet d'un mode de réalisation est que l'intégration du capteur de lumière au dispositif électroluminescent n'entraîne pas une diminution de la puissance lumineuse émise par le dispositif électroluminescent.

Un autre objet d'un mode de réalisation est que le rendement du capteur de lumière est amélioré.

Ainsi, un mode de réalisation prévoit un dispositif électroluminescent selon la revendication 1.

Selon un mode de réalisation, chaque élément semiconducteur tridimensionnel est majoritairement en un composé choisi parmi le groupe comprenant les composés III-V et les composés II-VI.

Selon un mode de réalisation, le substrat est, au moins en partie, en un matériau semiconducteur choisi parmi le groupe comprenant le silicium, le germanium, le carbure de silicium ou le GaAs.

Selon un mode de réalisation, le dispositif comprend, en outre, des pistes conductrices sur ladite face au contact des régions semiconductrices.

Selon l'invention, le dispositif comprend, en outre, une couche au moins partiellement réfléchissante recouvrant les régions semiconductrices, une couche isolante étant interposée entre les régions semiconductrices et ladite couche au moins partiellement réfléchissante.

Selon un mode de réalisation, les éléments semiconducteurs sont des nanofils, des microfils et/ou des structures pyramidales de taille nanométrique ou micrométrique.

Selon l'invention, le dispositif comprend, en outre, des régions isolantes électriquement s'étendant le long des bords latéraux d'au moins certaines régions semiconductrices.

Selon un mode de réalisation, le dispositif comprend, en outre, une couche isolante électriquement située en profondeur dans le substrat et comprend, pour chaque région semiconductrice, une région du premier type de conductivité interposée entre la couche isolante et la région semiconductrice.

Selon un mode de réalisation, les régions semiconductrices ont la forme de bandes connectées électriquement ou non.

Selon un mode de réalisation, les régions semiconductrices ont la forme d'un pavage hexagonal.

Selon un mode de réalisation, les régions semiconductrices forment une région continue traversée par lesdites portions.

Selon un mode de réalisation, les régions semiconductrices sont formées par implantation ionique de dopants.

Selon un mode de réalisation, les régions semiconductrices sont formées par épitaxie.

Selon un mode de réalisation, les diodes électroluminescentes sont réparties en au moins des premier et deuxième ensembles de diodes électroluminescentes commandés séparément.

Selon un mode de réalisation, les régions semiconductrices sont réparties en au moins des premier et deuxième ensembles de régions semiconductrices, les régions semiconductrices du premier ensemble de régions semiconductrices s'étendant dans le substrat depuis ladite face entre au moins certains des éléments semiconducteurs tridimensionnels du premier ensemble de diodes électroluminescentes et les régions semiconductrices du deuxième ensemble de régions semiconductrices s'étendant dans le substrat depuis ladite face entre au moins certains des éléments semiconducteurs tridimensionnels du deuxième ensemble de diodes électroluminescentes, les régions semiconductrices du premier ensemble de régions semiconductrices étant isolées électriquement des régions semiconductrices du deuxième ensemble de régions semiconductrices.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
les figures 1 à 3 sont des coupes, partielles et schématiques, de modes de réalisation de dispositifs électroluminescents à microfils ou nanofils ;
les figures 4A à 4F sont des vues de dessus, partielles et schématiques, de modes de réalisation de dispositifs électroluminescents illustrant plusieurs répartitions de régions du dispositif électroluminescent ;
la figure 5 est une coupe, partielle et schématique, d'un autre mode de réalisation d'un dispositif électroluminescent à microfils ou nanofils ;
la figure 6 est une coupe, partielle et schématique, d'une structure utilisée pour la réalisation de simulations ; et
la figure 7 est une courbe d'évolution de la puissance absorbée par le capteur de lumière en fonction du rayon du capteur de lumière.

### Description détaillée

Par souci de clarté, de mêmes éléments ont été désignés par de mêmes références aux différentes figures et, de plus, comme cela est habituel dans la représentation des circuits électroniques, les diverses figures ne sont pas tracées à l'échelle. En outre, seuls les éléments utiles à la compréhension de la présente description ont été représentés et sont décrits. En particulier, les moyens de commande des dispositifs électroluminescents décrits ci-après sont à la portée de l'homme de l'art et ne sont pas décrits. Dans la suite de la description, sauf indication contraire, les termes "sensiblement", "environ" et "de l'ordre de" signifient "à 10 % près". Par ailleurs, dans la présente description, on utilise le terme "connecté" pour désigner une liaison électrique directe, sans composant électronique intermédiaire, par exemple au moyen d'une piste conductrice, et le terme "couplé" ou le terme "relié", pour désigner soit une liaison électrique directe (signifiant alors "connecté") soit une liaison via un ou plusieurs composants intermédiaires (résistance, condensateur, etc.).

La présente description concerne des dispositifs électroluminescents comprenant des éléments semiconducteurs ayant la forme de microfils, de nanofils ou de pyramides.

Le terme "microfil" ou "nanofil" désigne une structure tridimensionnelle de forme allongée, par exemple cylindrique, conique ou tronconique, selon une direction privilégiée dont au moins deux dimensions, appelées dimensions mineures, sont comprises entre 50 nm et 2,5 µm, de préférence entre 300 nm et 2,5 µm, la troisième dimension, appelée dimension majeure, étant supérieure ou égale à 1 fois, de préférence supérieure ou égale à 5 fois et encore plus préférentiellement supérieure ou égale à 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 300 nm et 800 nm. Dans certains modes de réalisation, la hauteur de chaque microfil ou nanofil peut être supérieure ou égale à 500 nm, de préférence comprise entre 1 µm et 50 µm.

Dans la suite de la description, on utilise le terme "fil" pour signifier "microfil ou nanofil". De préférence, la ligne moyenne du fil qui passe par les barycentres des sections droites, dans des plans perpendiculaires à la direction privilégiée du fil, est sensiblement rectiligne et est appelée par la suite "axe" du fil. La base du fil a, par exemple, une forme ovale, circulaire ou polygonale, notamment triangulaire, rectangulaire, carrée ou hexagonale.

Dans la suite de la description, le terme pyramide ou pyramide tronquée désigne une structure tridimensionnelle de forme pyramidale. Cette structure pyramidale peut être tronquée, c'est-à-dire que le haut du cône est absent, laissant place à un plateau. La base de la pyramide est inscrite dans un polygone dont la dimension des côtés est de 100 nm à 10 µm, préférentiellement entre 1 et 3 µm. Le polygone formant la base de la pyramide peut être un hexagone. La hauteur de la pyramide entre la base de la pyramide et le sommet ou le plateau sommital varie de 100 nm à 20 µm, préférentiellement entre 1 µm et 10 µm.

Dans la suite de la description, des modes de réalisation vont être décrits dans le cas d'un dispositif électroluminescent à diodes électroluminescentes.

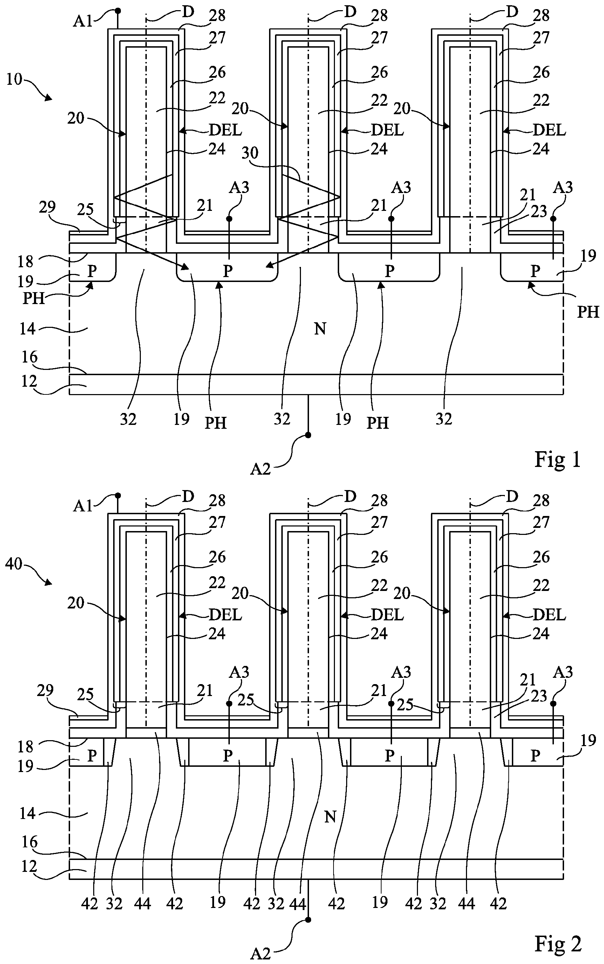

La figure 1 est une coupe, partielle et schématique, d'un dispositif électroluminescent 10 réalisé à partir de fils tels que décrits précédemment et adapté à émettre un rayonnement électromagnétique.

Le dispositif 10 comprend, du bas vers le haut en figure 1 :
une première électrode de polarisation 12 ;
un substrat 14, par exemple semiconducteur, dopé d'un premier type de conductivité, par exemple dopé de type N, et comprenant des faces parallèles 16 et 18, la face 16 étant au contact de l'électrode 12 ;
des régions semiconductrices 19 formées dans le substrat 14, dopées ou partiellement dopées d'un deuxième type de conductivité opposé au premier type de conductivité, par exemple dopées de type P, et s'étendant dans le substrat 14 depuis la face 18 sur une partie de l'épaisseur du substrat 14 ;
des éléments semiconducteurs 20, qui dans le présent mode de réalisation correspondent à des fils, trois fils 20 d'axe D parallèles étant représentés, chaque fil 20 comprenant une portion inférieure 21 du premier type de conductivité se prolongeant par une portion supérieure 22 du premier type de conductivité, la portion inférieure 21 reposant sur le substrat 14 et étant éventuellement en contact avec le substrat 14 ou séparée du substrat 14 par une portion de germination non représentée en figure 1 ;
une couche isolante électriquement 23 recouvrant la périphérie de la portion inférieure 21 de chaque fil 20 et recouvrant la face 18 entre les fils 20 ;
une coque 25 recouvrant la paroi extérieure 24 de la portion supérieure 22 de chaque fil 20, la coque 25 comprenant au moins un empilement d'une couche active 26 recouvrant la portion supérieure 22 et d'une couche semiconductrice 27 du deuxième type de conductivité recouvrant la couche active 26 ;
une couche de seconde électrode 28 recouvrant chaque coque 25 ; et
une couche conductrice 29, de préférence au moins en partie réfléchissante, par exemple une couche métallique, qui peut recouvrir la couche d'électrode 28 entre les fils 20 sans toutefois s'étendre sur les fils 20.

Le dispositif électroluminescent 10 comprend, en outre, une troisième électrode, non représentée, en contact avec les régions semiconductrices 19.

L'ensemble formé par un fil 20 et la coque 25 constitue une diode électroluminescente DEL. Lorsque plusieurs diodes électroluminescentes DEL sont formées sur le substrat 14, elles peuvent être connectées en série et/ou en parallèle et former un ensemble de diodes électroluminescentes. L'ensemble peut comprendre de quelques diodes électroluminescentes DEL à quelques milliers de diodes électroluminescentes DEL.

La jonction entre chaque région 19 dopée de type P et la partie dopée de type N du substrat 14, s'étendant autour de la région 19, forme une photodiode PH.

La deuxième électrode 28 est reliée à un noeud A1, la première électrode 12 est reliée à un noeud A2 et la troisième électrode est reliée à un noeud A3. La troisième électrode n'étant pas représentée en figure 1, chaque région semiconductrice 19 est représentée reliée au noeud A3.

En fonctionnement, la tension appliquée entre les électrodes 12 et 28 est telle que chaque diode électroluminescente DEL est passante de façon que la couche active 26 de chaque diode électroluminescente DEL émette un rayonnement lumineux. Pour chaque diode électroluminescente DEL, une partie du rayonnement émis par la couche active 26 de la diode électroluminescente DEL est guidée dans le fil 20 et s'échappe dans le substrat 14 par la base du fil 20. Ce rayonnement ne participe donc pas au rayonnement lumineux global émis par le dispositif électroluminescent 10 et qui est perçu par un observateur. On a représenté en figure 1 de façon schématique des exemples de trajets 30 de tels rayons lumineux. Les inventeurs ont mis en évidence que le rayonnement s'échappant par le pied de chaque fil 20 peut être capté, au moins partiellement, par la photodiode PH qui entoure le fil 20. Etant donné que le rapport entre la puissance lumineuse captée par chaque photodiode PH et la puissance lumineuse émise par les diodes électroluminescentes DEL avoisinantes peut être connu, le signal fourni par chaque photodiode PH est donc représentatif de la puissance lumineuse émise par les diodes électroluminescentes voisines de la photodiode PH.

Selon un mode de réalisation, les photodiodes PH sont polarisées en inverse. Le courant inverse de chaque photodiode PH dépend alors du rayonnement lumineux capté par la photodiode PH. Dans le mode de réalisation représenté en figure 1, cela signifie que le potentiel au noeud A3 est inférieur au potentiel au noeud A2.

Selon un autre mode de réalisation, les photodiodes PH sont polarisées en direct. Les photodiodes PH peuvent alors être utilisées comme capteur de température.

La couche conductrice 29 permet, de façon avantageuse, d'éviter que les photodiodes PH ne reçoivent un rayonnement lumineux par la face 18. La couche conductrice 29 améliore l'homogénéité de la répartition du courant dans la couche d'électrode 28.

Le substrat 14 peut correspondre à une structure monobloc ou correspondre à une couche recouvrant un support constitué d'un autre matériau. Le substrat 14 est de préférence un substrat semiconducteur, par exemple un substrat en silicium, en germanium, en carbure de silicium ou en GaAs. De préférence, le substrat 14 est un substrat de silicium monocristallin. De préférence, il s'agit d'un substrat semiconducteur compatible avec les procédés de fabrication mis en oeuvre en microélectronique. Le substrat 14 peut correspondre à une structure multicouches de type silicium sur isolant, également appelée SOI (acronyme anglais pour Silicon On Insulator). L'épaisseur du substrat 14 est, par exemple, comprise entre 10 µm et 1,5 mm.

Le substrat 14 est dopé du premier type de conductivité au moins sur une partie de son épaisseur depuis la face 18. Lorsque le substrat 14 est monobloc, il peut être dopé de façon uniforme. A titre de variante, le substrat 14 peut comprendre une région dopée du premier type de conductivité s'étendant depuis la face 18 dans l'épaisseur du substrat 14, seulement sur une partie de l'épaisseur du substrat 14, et reposant sur une région moins fortement dopée ou non dopée. Le substrat 14 est, par exemple, un substrat dopé du premier type de conductivité avec une concentration de dopants comprise entre 5^{∗}10¹⁶ atomes/cm³ et 2^{∗}10²⁰ atomes/cm³, de préférence comprise entre 5^{∗}10¹⁷ atomes/cm³ et 5^{∗}10¹⁹ atomes/cm³, par exemple environ 3^{∗}10¹⁸ atomes/cm³. Dans le cas d'un substrat 14 de silicium, des exemples de dopants de type P sont le bore (B) ou l'indium (In) et des exemples de dopants de type N sont le phosphore (P), l'arsenic (As), ou l'antimoine (Sb) . La face 18 du substrat 10 de silicium peut être une face (100) ou une face (111).

Chaque région semiconductrice 19 peut avoir une profondeur, mesurée depuis la face 18, comprise entre 200 nm et 4 µm, de préférence comprise entre 400 nm et 800 nm. Chaque région 19 est, par exemple, dopée du deuxième type de conductivité avec une concentration de dopants comprise entre 5^{∗}10¹⁶ atomes/cm³ et 1^{∗}10²² atomes/cm³, de préférence comprise entre 5^{∗}10¹⁷ atomes/cm³ et 5^{∗}10¹⁹ atomes/cm³, par exemple environ 6^{∗}10¹⁸ atomes/cm³. Les régions semiconductrices 19 ne s'étendent pas sous les fils 20 de sorte qu'une portion 32 dopée du premier type de conductivité s'étend jusqu'à la face 18 pour chaque fil 20.

Selon un mode de réalisation, chaque région semiconductrice 19 peut être formée par implantation ionique de dopants. Selon un autre mode de réalisation, la région semiconductrice 19 peut être formée par épitaxie. Selon un mode de réalisation, chaque région semiconductrice 19 est réalisée par au moins une étape d'implantation, qui peut être mise en oeuvre avant la formation des fils 20 et des coques 25 ou après la formation des fils 20 et des coques 25. De préférence, les régions semiconductrices 19 sont réalisées par au moins une étape d'implantation mise en oeuvre après la formation des fils 20 et des coques 25. Ceci permet d'éviter une diffusion des dopants depuis les régions semiconductrices 19 lors des étapes de formation des diodes électroluminescentes DEL. Lorsque les régions semiconductrices 19 sont réalisées par au moins une étape d'implantation mise en oeuvre après la formation des fils 20 et des coques 25, les fils 20 et les coques 25 peuvent être recouverts par une couche diélectrique de protection.

Selon un autre mode de réalisation, chaque région semiconductrice 19 peut se diviser en plusieurs sous-régions semiconductrices non dopées ou dopées du deuxième type de conductivité, avec une concentration de dopants qui augmente en s'éloignant du substrat 14 dopé du premier type de conductivité. Dans ce cas, les régions semiconductrices 19 peuvent être réalisées par plusieurs étapes d'implantation.

La première électrode 12 peut correspondre à une couche conductrice qui s'étend sur la face 16 du substrat 14. Le matériau formant l'électrode 12 est, par exemple, du siliciure de nickel (NiSi), de l'aluminium (Al), du siliciure d'aluminium (AlSi), du titane (Ti), du cuivre (Cu), du siliciure de tungstène (WSi₂) ou du siliciure de titane (TiSi). A titre de variante, l'électrode 12 peut être réalisée du côté de la face 18 autour de la zone du substrat 14 où sont formés les fils 20. La troisième électrode, non représentée, peut avoir la même composition que la première électrode 12.

La couche isolante 23 peut être en un matériau diélectrique, par exemple en oxyde de silicium (SiO₂), en nitrure de silicium (SiₓN_{y}, où x est environ égal à 3 et y est environ égal à 4, par exemple du Si₃N₄), en oxynitrure de silicium (notamment de formule générale SiOₓN_{y}, par exemple du Si₂ON₂), en oxyde d'hafnium (HfO₂) ou en diamant. A titre d'exemple, l'épaisseur de la couche isolante 23 est comprise entre 5 nm et 300 nm, par exemple égale à environ 100 nm. La couche isolante 23 peut avoir une structure monocouche ou correspondre à un empilement de deux couches ou de plus de deux couches.

Les éléments semiconducteurs 20 sont, au moins en partie, formés à partir d'au moins un matériau semiconducteur. Le matériau semiconducteur est choisi parmi le groupe comprenant les composés III-V ou les composés II-VI.

Les éléments semiconducteurs 20 peuvent être, au moins en partie, formés à partir de matériaux semiconducteurs comportant majoritairement un composé III-V, par exemple un composé III-N. Des exemples d'éléments du groupe III comprennent le gallium (Ga), l'indium (In) ou l'aluminium (Al). Des exemples de composés III-N sont GaN, AlN, InN, InGaN, AlGaN ou AlInGaN. D'autres éléments du groupe V peuvent également être utilisés, par exemple, le phosphore ou l'arsenic. De façon générale, les éléments dans le composé III-V peuvent être combinés avec différentes fractions molaires.

Les éléments semiconducteurs 20 peuvent être, au moins en partie, formés à partir de matériaux semiconducteurs comportant majoritairement un composé II-VI. Des exemples d'éléments du groupe II comprennent des éléments du groupe IIA, notamment le béryllium (Be) et le magnésium (Mg) et des éléments du groupe IIB, notamment le zinc (Zn), le cadmium (Cd) et le mercure (Hg). Des exemples d'éléments du groupe VI comprennent des éléments du groupe VIA, notamment l'oxygène (O) et le tellure (Te). Des exemples de composés II-VI sont ZnO, ZnMgO, CdZnO, CdZnMgO, CdHgTe, CdTe ou HgTe. De façon générale, les éléments dans le composé II-VI peuvent être combinés avec différentes fractions molaires.

Les éléments semiconducteurs 20 peuvent comprendre un dopant. A titre d'exemple, pour des composés III-V, le dopant peut être choisi parmi le groupe comprenant un dopant de type P du groupe II, par exemple, du magnésium (Mg), du zinc (Zn), du cadmium (Cd) ou du mercure (Hg), un dopant du type P du groupe IV, par exemple du carbone (C) ou un dopant de type N du groupe IV, par exemple du silicium (Si), du germanium (Ge), du sélénium (Se), du souffre (S), du terbium (Tb) ou de l'étain (Sn).

Lorsque les éléments semiconducteurs tridimensionnels 20 du dispositif optoélectronique correspondent à des fils, la hauteur totale de chaque fil peut être comprise entre 250 nm et 50 µm. Chaque fil 20 peut avoir une structure semiconductrice allongée selon un axe sensiblement perpendiculaire à la face 18. Chaque fil 20 peut avoir une forme générale cylindrique, dont la base a, par exemple, une forme ovale, circulaire ou polygonale, notamment triangulaire, rectangulaire, carrée ou hexagonale. Les axes de deux fils 20 adjacents peuvent être distants de 0,5 µm à 10 µm et de préférence de 1,5 µm à 5 µm. A titre d'exemple, les fils 20 peuvent être régulièrement répartis, notamment selon un réseau hexagonal.

Selon un mode de réalisation, la portion inférieure 21 de chaque fil est principalement constituée d'un composé III-N, par exemple du nitrure de gallium, dopé d'un premier type de conductivité, par exemple de type N. Le dopant de type N peut être le silicium. La hauteur de la portion inférieure 21 peut être comprise entre 200 nm et 25 µm.

Selon un mode de réalisation, la portion supérieure 22 de chaque fil est, par exemple, au moins partiellement réalisée dans un composé III-N, par exemple du nitrure de gallium. La portion 22 peut être dopée du premier type de conductivité, par exemple de type N, ou ne pas être dopée de façon intentionnelle. La hauteur de la portion 22 peut être comprise entre 500 nm et 25 µm.

A titre de variante, pour chaque fil 20, la couche isolante 23 peut s'étendre sur une partie de la portion supérieure 22, ne pas s'étendre sur la totalité de la portion inférieure 21 ou s'étendre sur une partie de la coque 25. A titre de variante, la coque 25 peut s'étendre sur toute ou partie de la portion inférieure 21.

Lorsque les éléments semiconducteurs tridimensionnels 20 du dispositif optoélectronique 10 correspondent à des pyramides, la hauteur de chaque pyramide peut être comprise entre 100 nm et 25 µm. Chaque pyramide peut avoir une structure semiconductrice allongée selon un axe sensiblement perpendiculaire à la face 18. La base de chaque pyramide peut avoir une forme générale de type ovale, circulaire ou polygonale, notamment triangulaire, rectangulaire, carrée ou hexagonale. Les centres de deux pyramides adjacentes peuvent être distants de 0,25 µm à 10 µm et de préférence de 1,5 µm à 5 µm. A titre d'exemple, les pyramides peuvent être régulièrement réparties, notamment selon un réseau hexagonal.

Dans le cas d'un fil 20 composé principalement de GaN, la structure cristalline du fil peut être du type wurtzite, le fil s'étendant selon la direction cristallographique c.

La couche active 26 est la couche depuis laquelle est émise la majorité du rayonnement fourni par le dispositif 10. La couche active 26 peut comporter des moyens de confinement. A titre d'exemple, la couche 26 peut comprendre un puits quantique unique. Elle comprend alors un matériau semiconducteur différent du matériau semiconducteur formant la portion supérieure 22 et la couche 27 et ayant une bande interdite inférieure à celle du matériau formant la portion supérieure 22 et la couche 27. La couche active 26 peut comprendre des puits quantiques multiples. Elle comprend alors un empilement de couches semiconductrices formant une alternance de puits quantiques et de couches barrières.

La couche semiconductrice 27 peut comprendre un empilement de plusieurs couches comprenant notamment :
- une couche intermédiaire de type de conductivité opposé à la portion supérieure 22 et recouvrant la couche active 26 ; et
- une couche de liaison recouvrant la couche intermédiaire et recouverte par l'électrode 28.

La couche intermédiaire, par exemple dopée de type P, peut correspondre à une couche semiconductrice ou à un empilement de couches semiconductrices et permet la formation d'une jonction P-N ou P-I-N, la couche active 26 étant comprise entre la couche intermédiaire de type P et la portion 22 de type N du fil 20 de la jonction P-N ou P-I-N.

La couche de liaison peut correspondre à une couche semiconductrice ou à un empilement de couches semiconductrices et permet la formation d'un contact ohmique entre la couche intermédiaire et l'électrode 28. A titre d'exemple, la couche de liaison peut être dopée très fortement du type opposé à la portion inférieure 36, jusqu'à dégénérer la ou les couches semiconductrices, par exemple dopée de type P à une concentration supérieure ou égale à 10²⁰ atomes/cm³.

L'empilement de couches semiconductrices peut comprendre une couche de blocage d'électrons formée d'un alliage ternaire, par exemple en nitrure de gallium et d'aluminium (AlGaN) ou en nitrure d'indium et d'aluminium (AlInN) en contact avec la couche active et la couche intermédiaire, pour assurer un bon confinement des porteurs électriques dans la couche active.

La deuxième électrode 28 est adaptée à polariser la couche active 26 recouvrant chaque fil 20 et à laisser passer le rayonnement électromagnétique émis par les diodes électroluminescentes DEL. Le matériau formant l'électrode 28 peut être un matériau transparent et conducteur tel que de l'oxyde d'indium-étain (ou ITO, acronyme anglais pour Indium Tin Oxide), de l'oxyde de zinc dopé ou non à l'aluminium ou au gallium, ou du graphène. A titre d'exemple, la couche d'électrode 28 a une épaisseur comprise entre 5 nm et 200 nm, de préférence entre 20 nm et 50 nm.

Un exemple de procédé de fabrication des diodes électroluminescentes DEL est décrit dans la demande de brevet US2014/0077151.

Selon un autre mode de réalisation, chaque élément semiconducteur 20 n'est pas en contact direct avec le substrat 14 mais repose sur une portion d'un matériau favorisant la croissance des éléments semiconducteurs 20, appelée plots de germination. A titre d'exemple, le matériau composant les plots de germination peut être un nitrure, un carbure ou un borure d'un métal de transition de la colonne IV, V ou VI du tableau périodique des éléments ou une combinaison de ces composés. A titre d'exemple, les plots de germination peuvent être en nitrure d'aluminium (AlN), en oxyde d'aluminium (Al₂O₃), en bore (B), en nitrure de bore (BN), en titane (Ti), en nitrure de titane (TiN), en tantale (Ta), en nitrure de tantale (TaN), en hafnium (Hf), en nitrure d'hafnium (HfN), en niobium (Nb), en nitrure de niobium (NbN), en zirconium (Zr), en borate de zirconium (ZrB₂), en nitrure de zirconium (ZrN), en carbure de silicium (SiC), en nitrure et carbure de tantale (TaCN), ou en nitrure de magnésium sous la forme MgₓN_{y}, où x est environ égal à 3 et y est environ égal à 2, par exemple du nitrure de magnésium selon la forme Mg₃N₂. Les plots de germination peuvent être dopés du même type de conductivité que le substrat 14. Les plots de germination ont, par exemple, une épaisseur comprise entre 1 nm et 100 nm, de préférence comprise entre 10 nm et 30 nm.

Lorsque les plots de germination sont en nitrure d'aluminium, ils peuvent être sensiblement texturés et posséder une polarité préférentielle. La texturation des plots de germination peut être obtenue par un traitement supplémentaire réalisé après le dépôt de la couche de germination. Il s'agit, par exemple, d'un recuit sous flux d'ammoniac (NH₃). Dans le cas d'un fil 20 composé principalement de GaN, chaque plot de germination peut favoriser la croissance du GaN avec la polarité N.

La figure 2 représente un autre mode de réalisation d'un dispositif électroluminescent 40. Le dispositif électroluminescent 40 comprend l'ensemble des éléments du dispositif électroluminescent 10 représenté en figure 1 et comprend, en outre, des régions isolantes électriquement 42 s'étendant dans le substrat 14 depuis la face 18 et entourant latéralement les régions semiconductrices 19. Les régions isolantes 42 sont, par exemple, en oxyde de silicium. Chaque région isolante 42 a de préférence une profondeur supérieure ou égale à la profondeur de la région semiconductrice 19 qu'elle entoure. Les régions isolantes 42 permettent de réduire les courants de fuite dans chaque photodiode PH dus à la polarisation des diodes électroluminescentes DEL. En outre, les régions isolantes 42 permettent de réduire la diffusion des dopants des régions semiconductrices 19 vers la portion 32. Les régions isolantes 42 sont, par exemple, obtenues par un procédé de formation de structures d'isolation par tranchées peu profondes ou structures STI (acronyme anglais pour Shallow Trench Insulation).

En figure 2, on a, en outre, représenté des plots de germination 44 sous chaque fil 20.

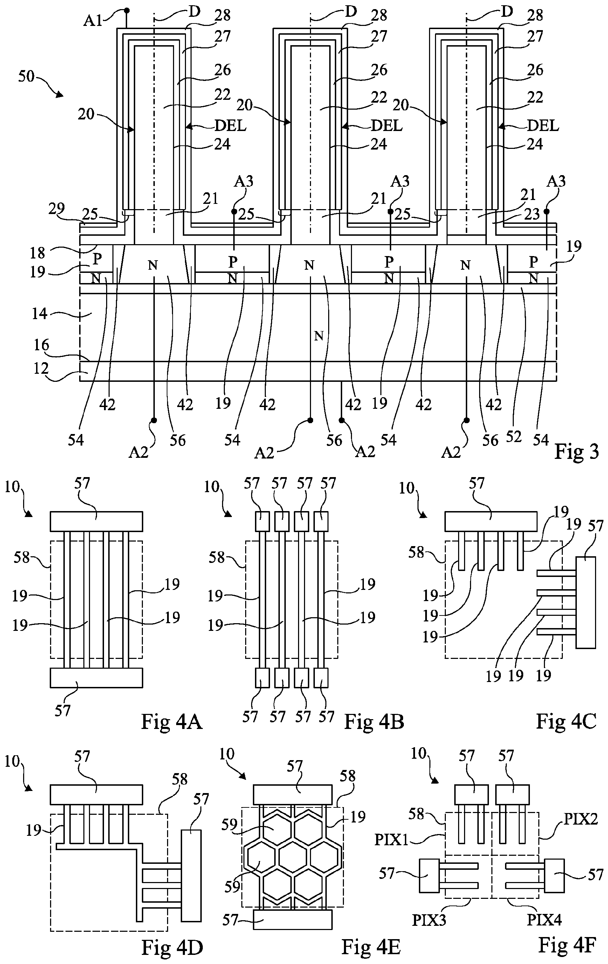

La figure 3 représente un autre mode de réalisation d'un dispositif électroluminescent 50. Le dispositif électroluminescent 50 comprend l'ensemble des éléments du dispositif électroluminescent 40 représenté en figure 2 et comprend, en outre, une couche isolante électriquement 52, située en profondeur dans le substrat 14, et délimitant avec les régions isolantes 42, pour chaque région semiconductrice 19, une région 54 du substrat 14 dopée du premier type de conductivité et isolée électriquement du reste du substrat 14. Chaque région 54 du premier type de conductivité est interposée entre l'une des régions semiconductrices 19 et la couche isolante 52. Chaque région 54 du premier type de conductivité est, en outre, de préférence entourée par la région isolante 42 qui entoure la région semiconductrice 19. La couche isolante 52 est, par exemple, en oxyde de silicium. Chaque photodiode est formée par la jonction entre la région semiconductrice 19 et la région 54 sous-jacente. Chaque région 54 est reliée à un noeud A4 (non représenté). La couche isolante 52 délimite, en outre, des régions 56 du substrat 14 dopées du premier type de conductivité sur lesquelles reposent les fils 20. Chaque région 56 est reliée au noeud A2. Le noeud A4 peut être électriquement relié au noeud A2. Dans ce cas, le noeud A4 et le noeud A2 sont au même potentiel électrique. Le substrat 14 correspond, par exemple, à une structure SOI. Le dispositif électroluminescent 50 présente des courants parasites au niveau des photodiodes qui sont réduits par rapport au dispositif électroluminescent 40.

Les figures 4A à 4F représentent des vues de dessus, partielles et schématiques de la face 18 du dispositif électroluminescent 10 et de plots conducteurs 57 correspondant à la troisième électrode A3 décrite précédemment. Sur les figures 4A à 4F, on a délimité par une ligne en traits pointillés la zone 58 de la face 18 du substrat 14 sur laquelle sont situés les fils 20, non représentés.

Comme cela apparaît sur ces figures, les plots conducteurs 57 sont, de préférence, situés en dehors de la zone 58 de la face 18 du substrat 14 sur laquelle sont situées les diodes électroluminescentes. Les régions semiconductrices 19 peuvent avoir une forme quelconque, par exemple la forme de bandes rectilignes et parallèles traversant complètement la zone 58, comme cela est représenté sur les figures 4A et 4B, de bandes rectilignes et parallèles traversant seulement partiellement la zone 58, comme cela est représenté sur les figures 4C et 4F, ou de bandes rectilignes qui s'entrecroisent comme cela est représenté en figure 4E et qui délimitent des ouvertures 59 hexagonales, chaque ouverture hexagonale 59 étant située au niveau d'un élément semiconducteur 20. Les régions semiconductrices 19 peuvent être distinctes, comme cela est représenté sur les figures 4A, 4B, 4C et 4F, ou être reliées les unes aux autres comme cela est représenté sur les figures 4D et 4E. Chaque plot conducteur 57 peut être connecté à l'ensemble des régions semiconductrices 19, comme cela est représenté sur les figures 4A, 4D et 4E ou seulement à certaines d'entre elles, comme cela est représenté sur les figures 4B, 4C et 4F. Comme cela est représenté en figure 4F, la zone 58 peut être divisée en plusieurs sous-régions PIX1, PIX2, PIX3 et PIX4, chaque plot conducteur 57 étant connecté aux régions semiconductrices 19 associées seulement à l'une de ces sous-régions PIX1, PIX2, PIX3 et PIX4. Une telle configuration permet notamment de traiter séparément les signaux fournis par les photodiodes associées à chaque sous-région PIX1, PIX2, PIX3 et PIX4. Les portions du substrat 14 associées à chaque pixel PIX1, PIX2, PIX3 et PIX4 peuvent être isolées électriquement les unes des autres de sorte que les diodes électroluminescentes de l'un des pixels PIX1, PIX2, PIX3 et PIX4 peuvent être commandées indépendamment des diodes électroluminescentes d'un autre pixel PIX1, PIX2, PIX3 et PIX4. Sur les figures 4A à 4F, les régions semiconductrices 19 sont représentées sous la forme de bandes. A titre de variante, les régions semiconductrices 19 peuvent correspondre, en vue de dessus, à un plan s'étendant sur tout ou partie de la zone 58 et traversé par des ouvertures, chaque ouverture étant située au niveau d'un élément semiconducteur 20.

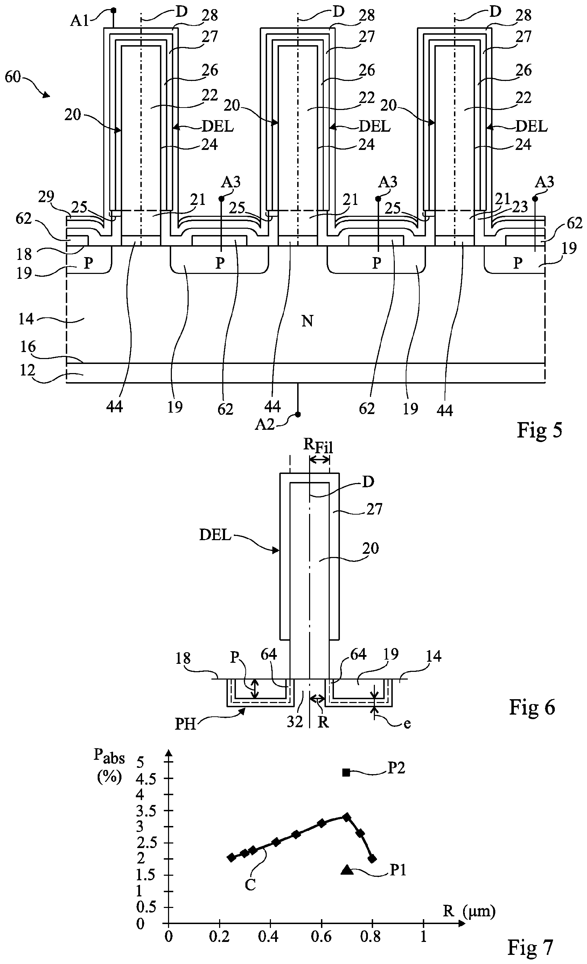

La figure 5 représente un autre mode de réalisation d'un dispositif électroluminescent 60. Le dispositif électroluminescent 60 comprend l'ensemble des éléments du dispositif électroluminescent 10 représenté en figure 1 et comprend, en outre, des pistes conductrices 62, par exemple métalliques, recouvrant les régions semiconductrices 19 et au contact des régions semiconductrices 19. Les pistes conductrices 62 sont reliées aux plots conducteurs 57, non représentés en figure 5. Les pistes conductrices 62 améliorent la conduction du courant des régions semiconductrices 19 vers les plots conducteurs 57. Dans le cas où des plots de germination 44 en un matériau conducteur sont présents, les pistes conductrices 62 peuvent être du même matériau que les plots de germination 44 et être réalisées simultanément aux plots de germination 44.

La figure 6 représente, de façon partielle et schématique, une structure simplifiée de la diode électroluminescente DEL qui a été utilisée pour déterminer par simulation l'évolution de la puissance lumineuse absorbée par la photodiode PH lorsque les dimensions de la photodiode PH varient. La diode électroluminescente DEL est représentée par le fil 20 et la couche semiconductrice 27. L'émission de lumière est réalisée à l'interface entre le fil 20 et la couche 27. Pour les simulations, la photodiode PH a été représentée par une zone de déplétion 64, également appelée zone de charge d'espace, qui se forme en fonctionnement à la jonction entre la région semiconductrice 19 de conductivité de type P et le reste du substrat 14 de type N. Pour les simulations, la région semiconductrice 19 entoure la portion 32 de type N du substrat 14 sous le fil 20 qui s'étend jusqu'au fil 20. On appelle e l'épaisseur de la zone de déplétion 64, P la profondeur de la région semiconductrice 19 et R le rayon moyen, entre l'axe D et le bord latéral interne de la zone de déplétion 64, c'est-à-dire le rayon moyen de la portion 32. La portion 32 peut avoir une section droite, perpendiculaire à l'axe D, ayant la forme d'un cercle. Dans ce cas, le rayon R correspond au rayon de la portion 32. La portion 32 peut avoir une section droite ayant la forme d'un polygone. Dans ce cas, le rayon moyen R correspond à la moyenne de la distance entre l'axe D et le bord latéral de la portion 32.

La figure 7 représente deux points P1 et P2 et une courbe C, obtenus par simulation à partir de la structure de la figure 6, d'évolution de la puissance lumineuse absorbée P_{abs} par la photodiode PH en fonction du rayon R. Pour les simulations, le rayon moyen du fil 20 était de 0,7 µm et la profondeur P était de 500 nm. Le point P1 a été obtenu pour une épaisseur e de la zone de déplétion 64 égale à 100 nm. Le point P2 a été obtenu pour une épaisseur e de la zone de déplétion 64 égale à 300 nm. La courbe C a été obtenue pour une épaisseur e de la zone de déplétion 64 égale à 200 nm. La puissance lumineuse absorbée P_{abs} est maximale lorsque le rayon moyen R est sensiblement égal au rayon moyen du fil 20. En outre, la puissance lumineuse absorbée P_{abs} augmente lorsque l'épaisseur e de la zone de déplétion 64 augmente. Toutefois, un compromis doit être trouvé entre l'épaisseur e de la zone de déplétion 64 et les dimensions de la région semiconductrice 19 qui doivent être suffisantes pour obtenir une conduction convenable du courant détecté par la photodiode PH.

Pour un courant injecté dans la diode électroluminescente DEL d'environ 10 µA et une efficacité quantique externe de la couche active 26 d'environ 80 %, la puissance maximale absorbée P_{abs} est de l'ordre de 2 % à 3 % et le courant fourni par la photodiode est d'environ 0,2 µA. L'intensité de ce courant est compatible avec les dispositifs utilisés de façon classique pour le traitement des signaux fournis par des capteurs.

Des modes de réalisation particuliers ont été décrits. Diverses variantes et modifications apparaîtront à l'homme de l'art. En particulier, bien que dans les modes de réalisation décrits précédemment les régions semiconductrices 19 soient dopées de type P et le substrat 14 et les fils 20 soient, au moins en partie, dopés de type N, il est clair que les types de conductivité peuvent être inversés. L'invention est définie par les revendications.

## Revendications

1. Dispositif électroluminescent (10 ; 40 ; 50 ; 60) comprenant :
un substrat (14) au moins partiellement dopé d'un premier type de conductivité et comprenant une face (18) ;
des diodes électroluminescentes (DEL) comprenant chacune au moins un élément semiconducteur tridimensionnel (20) non dopé ou dopé du premier type de conductivité et reposant sur ladite face, en contact avec ladite face ou séparée de ladite face par un plot de germination (44) ; et
des régions semiconductrices (19) formant des photodiodes (PH), au moins partiellement dopées d'un deuxième type de conductivité opposé au premier type de conductivité et s'étendant dans le substrat depuis ladite face entre au moins certains des éléments semiconducteurs tridimensionnels, telles que, pour chaque élément semiconducteur tridimensionnel, une portion (32) du substrat du premier type de conductivité s'étend jusqu'à ladite face (18) au contact de l'élément semiconducteur tridimensionnel ou du plot de germination (44) sur lequel repose l'élément tridimensionnel ;
**caractérisé en ce que** le dispositif comprend :
une couche (29) au moins partiellement réfléchissante recouvrant les régions semiconductrices (19) entre les éléments semiconducteurs tridimensionnels pour empêcher que les régions semiconductrices ne reçoivent un rayonnement lumineux par la face ;
une couche isolante (23) interposée entre les régions semiconductrices (19) et ladite couche au moins partiellement réfléchissante ; et
des régions isolantes électriquement (42) s'étendant le long des bords latéraux d'au moins certaines régions semiconductrices (19).

2. Dispositif électroluminescent selon la revendication 1, dans lequel chaque élément semiconducteur tridimensionnel (20) est majoritairement en un composé choisi parmi le groupe comprenant les composés III-V et les composés II-VI.

3. Dispositif électroluminescent selon la revendication 1 ou 2, dans lequel le substrat (14) est, au moins en partie, en un matériau semiconducteur choisi parmi le groupe comprenant le silicium, le germanium, le carbure de silicium ou le GaAs.

4. Dispositif électroluminescent selon l'une quelconque des revendications 1 à 3, comprenant, en outre, des pistes conductrices (62) sur ladite face (18) au contact des régions semiconductrices (19).

5. Dispositif électroluminescent selon l'une quelconque des revendications 1 à 4, dans lequel les éléments semiconducteurs (20) sont des nanofils, des microfils et/ou des structures pyramidales de taille nanométrique ou micrométrique.

6. Dispositif électroluminescent selon l'une quelconque des revendications 1 à 5, comprenant, en outre, une couche isolante électriquement (52) située en profondeur dans le substrat (14) et comprenant, pour chaque région semiconductrice (19), une région (54) du premier type de conductivité interposée entre la couche isolante (52) et la région semiconductrice (19).

7. Dispositif électroluminescent selon l'une quelconque des revendications 1 à 6, dans lequel les régions semiconductrices (19) ont la forme de bandes connectées électriquement ou non.

8. Dispositif électroluminescent selon l'une quelconque des revendications 1 à 6, dans lequel les régions semiconductrices (19) délimitent des ouvertures (59) hexagonales du substrat (14), chaque ouverture hexagonale (59) étant située au niveau d'un élément semiconducteur (20).

9. Dispositif électroluminescent selon l'une quelconque des revendications 1 à 6, dans lequel les régions semiconductrices (19) sont reliées les unes aux autres.

10. Dispositif électroluminescent selon l'une quelconque des revendications 1 à 9, dans lequel les régions semiconductrices (19) sont formées par implantation ionique de dopants.

11. Dispositif électroluminescent selon l'une quelconque des revendications 1 à 9, dans lequel les régions semiconductrices (19) sont formées par épitaxie.

12. Dispositif électroluminescent selon l'une quelconque des revendications 1 à 9, dans lequel les diodes électroluminescentes (DEL) sont réparties en au moins des premier et deuxième ensembles de diodes électroluminescentes commandés séparément.

13. Dispositif électroluminescent selon la revendication 12, dans lequel les régions semiconductrices (19) sont réparties en au moins des premier et deuxième ensembles de régions semiconductrices (19), les régions semiconductrices du premier ensemble de régions semiconductrices s'étendant dans le substrat depuis ladite face entre au moins certains des éléments semiconducteurs tridimensionnels du premier ensemble de diodes électroluminescentes et les régions semiconductrices du deuxième ensemble de régions semiconductrices s'étendant dans le substrat depuis ladite face entre au moins certains des éléments semiconducteurs tridimensionnels du deuxième ensemble de diodes électroluminescentes, les régions semiconductrices du premier ensemble de régions semiconductrices étant isolées électriquement des régions semiconductrices du deuxième ensemble de régions semiconductrices.

## Patentansprüche

1. Lichtemittierende Vorrichtung (10; 40; 50; 60), die Folgendes aufweist:
ein wenigstens teilweise dotiertes Substrat (14) eines ersten Leitfähigkeitstyps, das eine Oberfläche (18) aufweist;
lichtemittierende Dioden (DEL), die jeweils wenigstens ein undotiertes oder dotiertes dreidimensionales Halbleiterelement (20) vom ersten Leitfähigkeitstyp auf der Oberfläche aufweisen, und zwar in Kontakt mit der Oberfläche oder durch eine Keimunterlage (44) von der Oberfläche getrennt; und
Halbleiterbereiche (19), die Photodioden (PH) bilden, die wenigstens teilweise dotiert sind, die einen zweiten Leitfähigkeitstyp entgegengesetzt zum ersten Leitfähigkeitstyp aufweisen und die sich im Substrat von der Oberfläche zwischen wenigstens einigen der dreidimensionalen Halbleiterelemente erstrecken, so dass sich für jedes dreidimensionale Halbleiterelement ein Teil (32) des Substrats vom ersten Leitfähigkeitstyp bis zur Oberfläche (18) erstreckt, die mit dem dreidimensionalen Halbleiterelement oder mit der Keimunterlage (44), auf dem das dreidimensionale Element ruht, in Kontakt steht;
**dadurch gekennzeichnet, dass** die Vorrichtung Folgendes aufweist
eine wenigstens teilweise reflektierende Schicht (29), die die Halbleiterbereiche (19) zwischen den dreidimensionalen Halbleiterelementen bedeckt, um zu vermeiden, dass die Halbleiterbereiche eine Lichtstrahlung durch die Oberfläche empfangen;
eine Isolierschicht (23), die zwischen den Halbleiterbereichen (19) und der wenigstens teilweise reflektierenden Schicht angeordnet ist; und
elektrisch isolierende Bereiche (42), die sich entlang der Seitenkanten wenigstens einiger Halbleiterbereiche (19) erstrecken.

2. Lichtemittierende Vorrichtung nach Anspruch 1, wobei jedes dreidimensionale Halbleiterelement (20) hauptsächlich aus einer Verbindung hergestellt ist, die aus der Gruppe ausgewählt ist, die III-V-Verbindungen und II-VI-Verbindungen aufweist.

3. Lichtemittierende Vorrichtung nach Anspruch 1 oder 2, wobei das Substrat (14) wenigstens teilweise aus einem Halbleitermaterial hergestellt ist, das aus der Gruppe ausgewählt ist, die Silizium, Germanium, Siliziumkarbid oder GaAs aufweist.

4. Lichtemittierende Vorrichtung nach einem der Ansprüche 1 bis 3, ferner aufweisend Leiterbahnen (62) auf der Oberfläche (18) in Kontakt mit den Halbleiterbereichen (19).

5. Lichtemittierende Vorrichtung nach einem der Ansprüche 1 bis 4, wobei die Halbleiterelemente (20) Nanodrähte, Mikrodrähte und/oder pyramidenförmige Strukturen im Nano- oder Mikrometerbereich sind.

6. Lichtemittierende Vorrichtung nach einem der Ansprüche 1 bis 5, ferner aufweisend eine elektrisch isolierende Schicht (52), die in der Tiefe des Substrat (14) angeordnet ist und für jeden Halbleiterbereich (19) einen Bereich (54) des ersten Leitfähigkeitstyps, der zwischen der isolierendenden Schicht (52) und dem Halbleiterbereich (19) angeordnet ist.

7. Lichtemittierende Vorrichtung nach einem der Ansprüche 1 bis 6, wobei die Halbleiterbereiche (19) die Form von Streifen aufweisen, die elektrisch verbunden sind oder nicht.

8. Lichtemittierende Vorrichtung nach einem der Ansprüche 1 bis 6, wobei die Halbleiterbereiche (19) hexagonale Öffnungen (59) des Substrats (14) begrenzen, wobei jede hexagonale Öffnung (59) auf der Ebene eines Halbleiterelements (20) angeordnet ist.

9. Lichtemittierende Vorrichtung nach einem der Ansprüche 1 bis 6, wobei die Halbleiterbereiche (19) miteinander verbunden sind.

10. Lichtemittierende Vorrichtung nach einem der Ansprüche 1 bis 9, wobei die Halbleiterbereiche (19) durch Ionenimplantation von Dotierstoffen gebildet sind.

11. Lichtemittierende Vorrichtung nach einem der Ansprüche 1 bis 9, wobei die Halbleiterbereiche (19) durch Epitaxie gebildet sind.

12. Lichtemittierende Vorrichtung nach einem der Ansprüche 1 bis 9, wobei die lichtemittierenden Dioden (DEL) in wenigstens erste und zweite separat gesteuerte lichtemittierende Dioden bzw. Diodengruppen unterteilt sind.

13. Lichtemittierende Vorrichtung nach Anspruch 12, wobei die Halbleiterbereiche (19) in mindestens erste und zweite Anordnungen von Halbleiterbereichen (19) unterteilt sind, wobei sich die Halbleiterbereiche der ersten Anordnung von Halbleiterbereichen im Substrat von der Oberfläche aus zwischen wenigstens einigen der dreidimensionalen Halbleiterelemente der ersten Anordnung von lichtemittierenden Dioden erstrecken und sich die Halbleiterbereiche der zweiten Anordnung von Halbleiterbereichen im Substrat von der Oberfläche aus zwischen wenigstens einigen der dreidimensionalen Halbleiterelemente der zweiten Anordnung von lichtemittierenden Dioden erstrecken, wobei die Halbleiterbereiche der ersten Anordnung von Halbleiterbereichen elektrisch von den Halbleiterbereichen der zweiten Anordnung von Halbleiterbereichen isoliert sind.

## Claims

1. A light-emitting device (10; 40; 50; 60) comprising:
an at least partially doped substrate (14) of a first conductivity type, comprising a surface (18);
light-emitting diodes (DEL), each comprising at least one non-doped or doped three-dimensional semiconductor element (20) of the first conductivity type, resting on said surface, in contact with said surface or separated from said surface by a seed pad (44); and
semiconductor regions (19) forming photodiodes (PH), at least partially doped of a second conductivity type opposite to the first conductivity type and extending in the substrate from said surface between at least some of the three-dimensional semiconductor elements such that, for each three-dimensional semiconductor element, a portion (32) of the substrate of the first conductivity type extends all the way to said surface (18) in contact with the three-dimensional semiconductor element or with the seed pad (44) on which the three-dimensional element rests;
**characterized in that** the device comprises:
an at least partially reflective layer (29) covering the semiconductor regions (19) between the three-dimensional semiconductor elements to avoid the semiconductor regions to receive a light radiation through the surface;
an insulating layer (23) interposed between the semiconductor regions (19) and said at least partially reflective layer; and
electrically-insulating regions (42) extending along the lateral edges of at least some semiconductor regions (19).

2. The light-emitting device of claim 1, wherein each three-dimensional semiconductor element (20) is mainly made of a compound selected from the group comprising III-V compounds and II-VI compounds.

3. The light-emitting device of claim 1 or 2, wherein the substrate (14) is at least partly made of a semiconductor material selected from the group comprising silicon, germanium, silicon carbide, or GaAs.

4. The light-emitting device of any of claims 1 to 3, further comprising conductive tracks (62) on said surface (18) in contact with the semiconductor regions (19).

5. The light-emitting device of any of claims 1 to 4, wherein the semiconductor elements (20) are nanowires, microwires, and/or nanometer- or micrometer-range pyramidal structures.

6. The light-emitting device of any of claims 1 to 5, further comprising an electrically-insulating layer (52) located in depth in the substrate (14) and comprising, for each semiconductor region (19), a region (54) of the first conductivity type interposed between the insulating layer (52) and the semiconductor region (19).

7. The light-emitting device of any of claims 1 to 6, wherein the semiconductor regions (19) have the shape of strips, electrically connected or not.

8. The light-emitting device of any of claims 1 to 6, wherein the semiconductor regions (19) delimit hexagonal openings (59) of the substrate (14), each hexagonal opening (59) being located at the level of a semiconductor element (20).

9. The light-emitting device of any of claims 1 to 6, wherein the semiconductor regions (19) are linked the one to the other.

10. The light-emitting device of any of claims 1 to 9, wherein the semiconductor regions (19) are formed by ion implantation of dopants.

11. The light-emitting device of any of claims 1 to 9, wherein the semiconductor regions (19) are formed by epitaxy.

12. The light-emitting device of any of claims 1 to 9, wherein the light-emitting diodes (DEL) are distributed into at least first and second separately controlled light-emitting diodes.

13. The light-emitting device of claim 12, wherein the semiconductor regions (19) are distributed into at least first and second assemblies of semiconductor regions (19), the semiconductor regions of the first assembly of semiconductor regions extending in the substrate from said surface between at least some of the three-dimensional semiconductor elements of the first assembly of light-emitting diodes and the semiconductor regions of the second assembly of semiconductor regions extending in the substrate from said surface between at least some of the three-dimensional semiconductor elements of the second assembly of light-emitting diodes, the semiconductor regions of the first assembly of semiconductor regions being electrically insulated from the semiconductor regions of the second assembly of semiconductor regions.
